Europäisches Patentamt

European Patent Office

Office européen des brevets

(11) Publication number: **0 145 316**
**B1**

# (12) EUROPEAN PATENT SPECIFICATION

(45) Date of publication of patent specification: **07.03.90**

(51) Int. Cl.⁵: **H 01 L 33/00, H 01 L 31/02**

(21) Application number: **84307870.0**

(22) Date of filing: **14.11.84**

(60) **Divisional application 88202641.2 filed on 14/11/84.**

(54) Optical device and package for optical device.

(30) Priority: **21.11.83 JP 218964/83**
**25.11.83 JP 223020/83**
**08.12.83 JP 232341/83**

(43) Date of publication of application:
**19.06.85 Bulletin 85/25**

(45) Publication of the grant of the patent:
**07.03.90 Bulletin 90/10**

(84) Designated Contracting States:
**DE FR GB NL SE**

(56) References cited:
**EP-A-0 017 701**
**EP-A-0 089 044**
**WO-A-82/02800**
**FR-A-2 428 328**

**PATENTS ABSTRACTS OF JAPAN, vol. 4, no. 44 (E-5) 526r, 5th April 1980; & JP - A - 55 13 963 (NIPPON DENKI K.K.) 31-01-1980**

(73) Proprietor: **SUMITOMO ELECTRIC INDUSTRIES, LTD.**
**5-33, Kitahama 4-chome Chuo-ku**
**Osaka-shi Osaka (JP)**

(72) Inventor: **Nishizawa, Hideaki Osaka Works Sumitomo Electric Ind. Ltd. 1-3, Shimaya 1-chome**
**Konohana-ku Osaka (JP)**

(74) Representative: **Rackham, Stephen Neil et al GILL JENNINGS & EVERY 53-64 Chancery Lane London WC2A 1HN (GB)**

Courier Press, Leamington Spa, England.

## Description

The present invention relates to optical devices such as light-emitting diodes and photodiodes and packages for such optical devices.

In an optical device such as a light emitting device or a light receiving device, and a package for such optical device, there are the following technological requirements:

(a) It must have a light transmitting structure which is transparent to light;

(b) It must be wired by die bonding or wire bonding to lead electrode terminals out of it;

(c) Its chip must be sealed off hermetically; and,

(d) It must have a high coupling efficiency with an optical fibre. That is, a light emitting diode chip or a photodiode chip must be capable of being mounted sufficiently closely to an optical fibre end face and must have a large opening angle to obtain the greatest degree of coupling. Further, the chip must have a clean light receiving or transmitting surface which is not obscured with any other material.

Various attempts have been made to improve devices to meet the above requirements, particularly requirement (d) and a number of these will be discussed subsequently.

According to this invention a package for an optical device including:

a sapphire substrate, and

a die bonding pad formed on an upper surface of the sapphire substrate by printing and subsequently firing an electroconductive paste, the electroconductive paste being absent from a region to form an opening in the die bonding pad to enable light to pass through the sapphire substrate and the opening, is characterised in that the upper surface of the sapphire substrate includes a depression having inclined sides, and in that the electroconductive paste has its edges surrounding the opening located on the inclined sides of the depression, so that, after firing, the upper contact surface of the die bonding pad is substantially flat.

Particular examples of devices in accordance with this invention will now be described and contrasted with conventional devices with reference to the accompanying drawings; in which:

Figure 1 is a section through a conventional upper surface type package for an optical device, having a glass window in the upper surface;

Figure 2 is a section through a conventional upper surface type package for an optical device, having a sapphire window in the upper surface;

Figures 3 to 5 are sections through conventional lower surface through hole type packages for an optical device;

Figure 6 is a section to a larger scale illustrating the light incident on a light receiving portion in a conventional lower surface through hole type optical device;

Figure 7 is a section to a larger scale illustrating the light incident on a light receiving portion in a conventional lower surface through hole type optical device when an optical device chip is not mounted in its required position;

Figure 8 is a plan of a conventional sapphire substrate type of package with its cover removed;

Figure 9 is a section taken along the line IX-IX shown in Figure 8;

Figure 10 is a section through a complete optical device in which an optical device chip is die-bonded into the package shown in Figure 9;

Figure 11 is a plan to a larger scale of a portion of the die bonding pad;

Figure 12 is a section taken along the line XII-XII shown in Figure 11;

Figure 13 is a section to a larger scale showing the gold paste screen-printed on a sapphire substrate;

Figure 14 is a section to a larger scale showing the state of the sapphire substrate with the die bonding pad formed by gold paste after firing;

Figure 15 is a section to a larger scale showing an optical device chip mounted on the die bonding pad;

Figure 16 is a section through an example of a conventional mesa type photodiode chip;

Figure 17 is a section through a conventional ceramic substrate type bonding pad having a light introducing hole;

Figure 18 is a section through the conventional ceramic substrate bonding pad having a solder ring mounted on it;

Figure 19 is a section through a complete device in which a photodiode chip is mounted on the substrate shown in Figure 18;

Figure 20 is a section similar to Figure 18 but illustrating a package in which the solder ring is mounted off its required position;

Figure 21 is a section similar to Figure 19 showing a complete device in which a photodiode chip is mounted on the package shown in Figure 20;

Figure 22 is a section through a sapphire substrate;

Figure 23 is a section through the sapphire substrate shown in Figure 22 modified in accordance with an aspect of this invention;

Figure 24 is a section through the substrate shown in Figure 23 with gold paste screen-printed on to it;

Figure 25 is a section through the substrate shown in Figure 24 after firing;

Figure 26 is a section through a device in accordance with this invention illustrating the relationship between the light receiving portion and the opening angle of the optical device chip;

Figure 27 is a section through an example of a mesa type photodiode in accordance with an aspect of the present invention;

Figure 28 is a section through the mesa type photodiode shown in Figure 27 when disposed on a sapphire substrate package; and,

Figure 29 is a section through the mesa type photodiode shown in Figure 27 when disposed on a ceramic substrate package.

Prior Art I Upper Surface Type

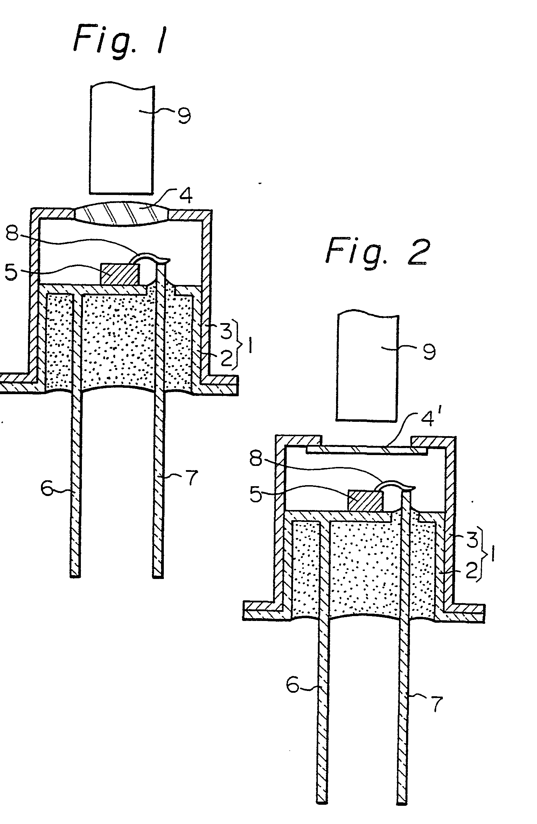

Figure 1 is a sectional view of a prior art package for a photodiode. This package is a most common type in which light of an optical fibre is incident to it through the upper surface of it. In Figure 1, a TO18 type package 1 comprises a package body 2 and a cap 3 to cover the upper surface of the body 2. The cap 3 has an opening at the centre of the top thereof, which has a transparent kovar glass therein to serve as a window 4. A photodiode chip 5 is die-bonded to the top plate of the package body 2. The top plate of the package body 2 is provided with a lead 6. Another lead 7 and an electrode on the photodiode chip 5 are wire-bonded with each other by a gold wire 8. An optical fibre 9 is disposed outside of the window 4 in opposition to the photodiode chip 5.

The cap 3 and the body 2 are welded together on their sides. This package is of a hermetically sealed type which has been bringing satisfactory results for a long time. In this package, since light is incident on to it from the upper surface where the wire bonding (gold wire 8) exists, the window 4 must be spaced from the upper surface of the photodiode chip 5 and this results in a disadvantage that the coupling efficiency with the optical fibre 9 is low.

Figure 2 shows another package for an optical device of the upper surface type as shown in Figure 1, in which a sapphire plate 4' is mounted in the window in place of the transparent kovar glass 4. The package shown in Figure 2 has likewise the disadvantage that the coupling efficiency with the optical fibre 9 is low because the photodiode chip 5 and the sapphire plate 4' are separated from each other by sufficient distance to accommodate the gold wire 8 wire-bonded to the chip 5.

Prior Art II Through Hole on Under Surface Type

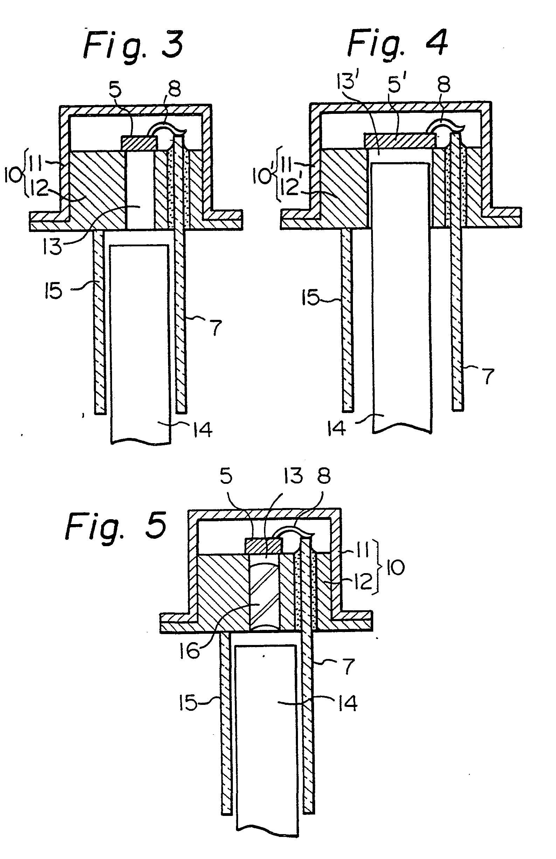

It is easier to get the optical fibre and the chip close to each other from the under surface than from the upper surface because the wire on the upper surface gives a limit to the closeness of approach from the upper surface. Therefore, through hole on under surface type packages for an optical device shown in Figures 3 to 5 have been produced. In Figure 3, a package 10 comprises a package body 12 and a cap 11. In this example, the cap 11 has no window. The package body 12 is provided with a large through hole 13 defined axially under the photodiode chip 5. An optical fibre 14 is disposed under the through hole 13 having its upper end face opposed to the lower opening of the through hole 13. The light from the optical fibre 14 is incident on the photodiode chip 5 from its under surface through the through hole 13. In Figures 3 to 5, designated by numeral 15 are leads equivalent to the leads 6 in Figures 1 and 2.

Figure 4 shows an example of the package in which the through hole 13' is larger and the upper end portion of the optical fibre 14 is inserted into it and fixed to reduce the distance between the photodiode chip 5' and the end of the optical fibre 14 still further. This example has, however, the disadvantages that the upper end of the optical fibre 14 inserted into the through hole 13' may come in contact with the photodiode chip 5' and damage it and that the fixing of the optical fibre 14 is difficult.

Figure 5 shows an example of the package in which the through hole 13 is sealed off by a kovar glass piece 16.

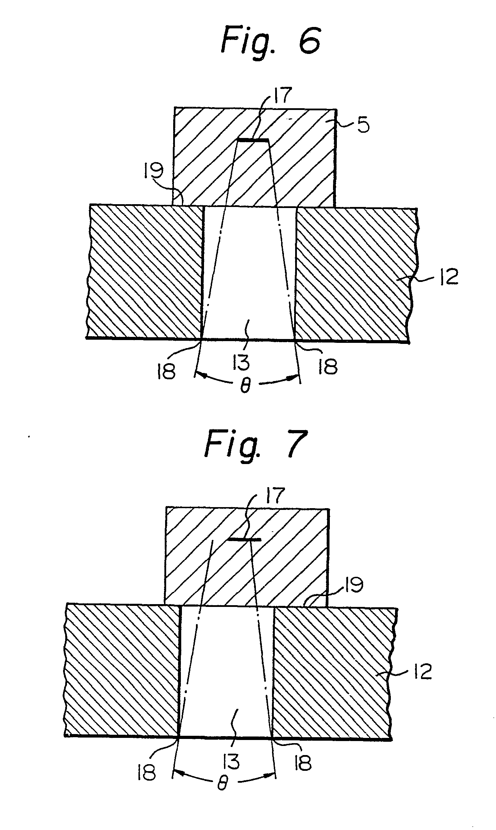

Disadvantages of these through hole on under surface type packages will be described with reference to enlarged sectional views of Figures 6 and 7 taking the case of Figure 3 as an example.

A pn junction of the photodiode chip 5 behaves as a light receiver 17 to which the light is incident from below through the through hole 13. Since the light is limited by the edge 18 of the through hole 13, only the light within the opening angle θ reaches the light receiver 17. Even if the end face of the optical fibre 14 is brought into contact with the under surface of the package body 12, it is still limited by the opening angle θ.

Mounting of the photodiode chip 5 is difficult. The through hole 13 is round in section and the photodiode chip 5 is die-bonded to the cap 11 on the contact region 19 exclusive of the through hole 13. Since the chip 5 is small and the through hole 13 is also small in section, alignment of them is difficult. If the centre of the light receiver 17 is displaced to one side of the central axis of the through hole 13, as shown in Figure 7, the quantity of light received by the light receiver 17 is smaller on the side to which it is displaced than on the other side. In Figure 7, the chip 5 is displaced to the right side and, accordingly, a smaller quantity of light reaches the right half of the light receiver 17 than its left half. Reduction in the quantity of the light incident to the photodiode decreases the detection sensitivity.

To enlarge the opening angle of the light incident on the light receiver 17, the through hole 13 must be reduced in length and increased in cross sectional area. The length of the through hole 13 is equal to the thickness of the package body 12. Reduction in thickness of the package body 12 makes its mechanical strength insufficient. The body 12 is made of metal or ceramic and it cannot be reduced in thickness unduly because it is the mechanical centre to support the chip, lead and cap. A larger diameter of the through hole 13 necessitates a larger size of the photodiode chip 5, and a larger size of semiconductor results in higher cost and lower strength of the chip.

Prior Art III Sapphire Substrate Type

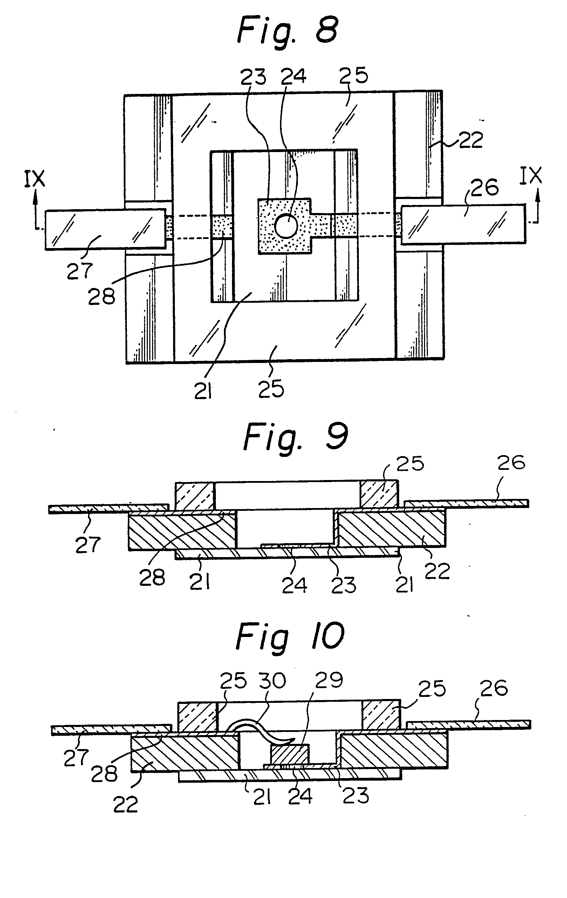

Accordingly, we have previously invented a package for an optical device, in which a sapphire substrate is provided with a die bonding pad having an opening, an optical device is die-bonded to the pad, and an end of an optical fibre is placed adjacent the rear face of the sapphire substrate. Figures 8, 9 and 10 show such a package.

In the structure of the package shown in Figures 8 to 10, a lower frame 22 is bonded to a sapphire substrate 21. The lower frame 22 is made of sintered alumina in this example but may be made of any insulator. The lower frame 22 is bonded to the sapphire substrate 21 by brazing. An electroconductive die bonding pad 23 having an opening 24 is disposed at the centre of the sapphire substrate 21 by metallizing. The die bonding pad 23 extends beyond an inner edge of the lower frame 22 to an outer edge thereof. The opening 24 is for passing light. While the opening 24 is shown as round in shape, it may, of course, be of other shape, for example, square. An upper frame 25 is bonded to the lower frame 22. The upper frame 26 and the lower frame 22 are bonded together by an insulating bonding agent. A lead 26 is soldered to the extended portion of the die bonding pad 23. A wire bonding pad 28 is metallized to the inner edge of the lower frame 22 opposite to the die bonding pad 23. A lead 27 is soldered to the extended portion of the wire bonding pad 28. An optical device chip 29 such as a photodiode or a light emitting diode is bonded to the package as shown in Figure 10. The optical device chip 29 is mounted on the die bonding pad 23 in such a way that the opening 24 and the optical device chip 29 are aligned with each other. The die bonding pad 23 is a solder ring of, for example, an AuSn eutectic crystal. By applying energy such as ultrasonic wave to the optical device chip 29 which is held down, the solder is melted to fix the chip 29 on the pad 23. Further, a wire 30 of, for example, gold is wire-bonded to connect the wire bonding pad 28 with the electrode of the optical device chip 29. Normally, an alumina cap is bonded to the upper frame 25 to seal off the inner space of the package.

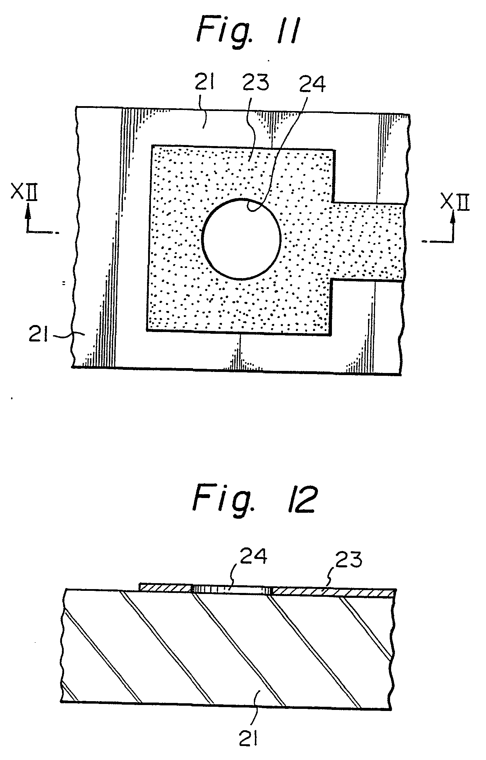

Figure 11 is an enlarged plan view of a portion of the die bonding pad 23 surrounding the opening 24, and Figure 12 is a sectional view taken along the line XII-XII of Figure 11. Ideally, the sapphire substrate 21 and the die bonding pad 23 would both be flat as shown in Figure 12 but, in practice this does not happen. If the pad 23 is perfectly flat, the optical device chip 29 can be fixed accurately at the predetermined position in a stable state. Actually, however, the die bonding pad 23 is not flat for the reason described below.

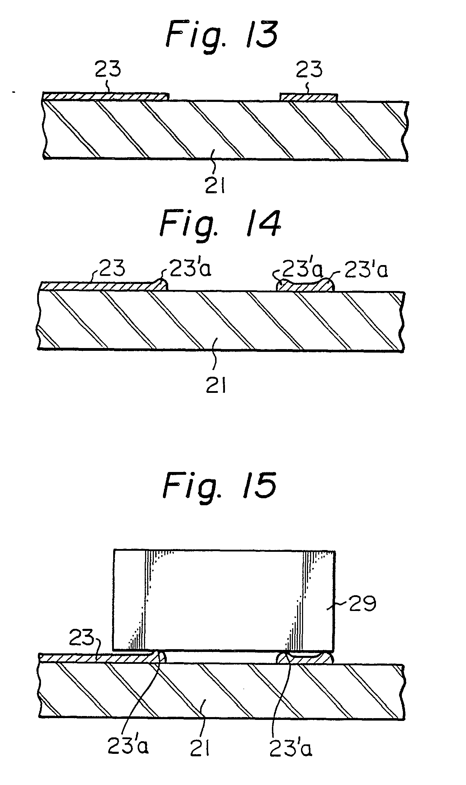

Figure 13 is a sectional view of the sapphire substrate during production in which paste of an electroconductive material (for example, gold or AuSn eutectic crystal) is printed on the sapphire substrate 21 in a silk screen printing operation. Since it is thick film printing, a thin screen with an opening identical in shape to the pad is placed on the sapphire substrate 21, and gold paste 23' is applied onto the screen. In this state, the applied gold paste 23' is flat in its upper surface. Then, the sapphire substrate 21 is placed in a furnace and fired to solidify the gold paste. In the firing process, the gold paste 23' rises up at edges 23'a by a surface tension effect. For this reason, the gold paste 23' becomes higher at edges 23'a than in other portions. When removed from the furnace, the gold paste solidifies in an indeterminate shape. Figure 14 is a sectional view of a typical pad after the firing process. Figure 15 is a sectional view of the pad on which the optical device chip 29 is die-bonded. Depressions and bumps are caused on the upper surface of the paste by expansion and contraction of the paste during the firing process. The depressions and bumps on the paste are approximately several μm in height, but since the optical device chip 29 is also small in size, the flat chip tends to be inclined or incompletely fixed when bonded to a die-bonding pad having such depressions and bumps. Further, the chip is easily detached by a weak shock or vibration.

Prior Art IV Mesa Type Photo Diode

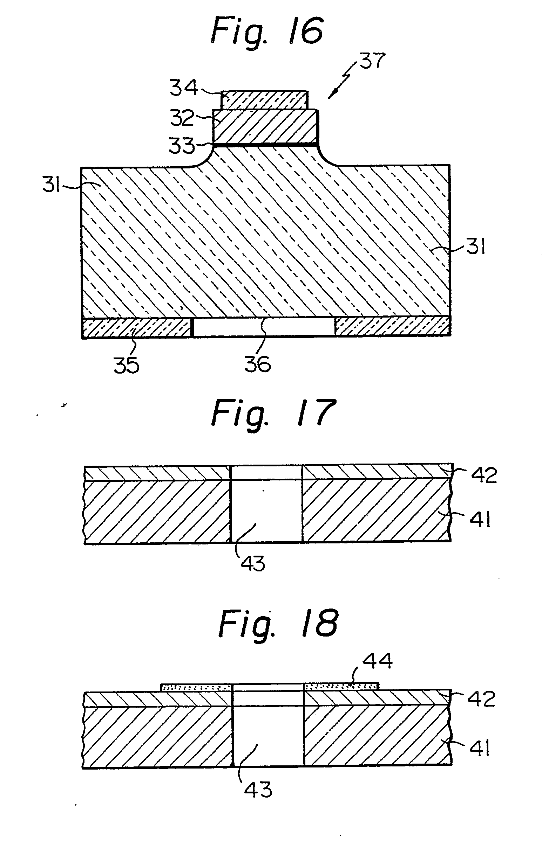

Another problem is high speed operation of the photodiode. Since the photodiode is used in an inversely biased state, the electrostatic capacity in the pn junction obstructs its high speed operation. Reduction in area of the light receiving region (pn junction) is effective to reduce the electrostatic capacity. For this purpose, a mesa structure as shown in Figure 16 is used.

A p-InP layer 32 is formed on an n-InP substrate 31 as by epitaxial growth. A narrow pn junction 33 between the substrate 31 and the layer 32 functions as the light receiving region. Further, the p-InP layer 32 and the pn junction 33 are etched off in stripes toward the upper portion of the n-InP substrate 31 on both sides to reduce the area of the light receiving region. Since the p-InP layer 32 is narrowed in stripes, a ring-shaped electrode can no longer be mounted on it. Accordingly, a stripe-shaped p-type Au-Zn electrode 34 is used. Then, it is impossible to pass the light from the player. Instead a ring-shaped n-type AuGeNi electrode 35 is fixed to the bottom of the n-InP substrate 31. Then, the central portion of the bottom of the n-InP substrate 31 serves as a light receiving surface 36 through which the light passes. Therefore, under surface incident types shown in Figures 3, 4, 5 and 8 to 12 are demanded also for high speed operation of the photodiode.

A chip 37 of the photodiode described above is made by a wafer process in which, after a number of devices are made, the wafer is scribed and divided into chips 37. The chip 37 must be packaged. There is a further problem in mounting the photodiode chip 37 on the pad.

Prior Art V Ceramic Substrate Type

As an example intermediate between the example shown in Figures 3 to 5 and the example shown in Figures 8 to 12, there is a package using a ceramic substrate having a hole therethrough. Since the ceramic substrate is not conductive, a metal is evaporated on to it to form a die bonding pad which is slightly different in technical meaning from the pad of the example described in the preceding paragraph. Solder is placed on the pad, on which an optical device is placed and soldered.

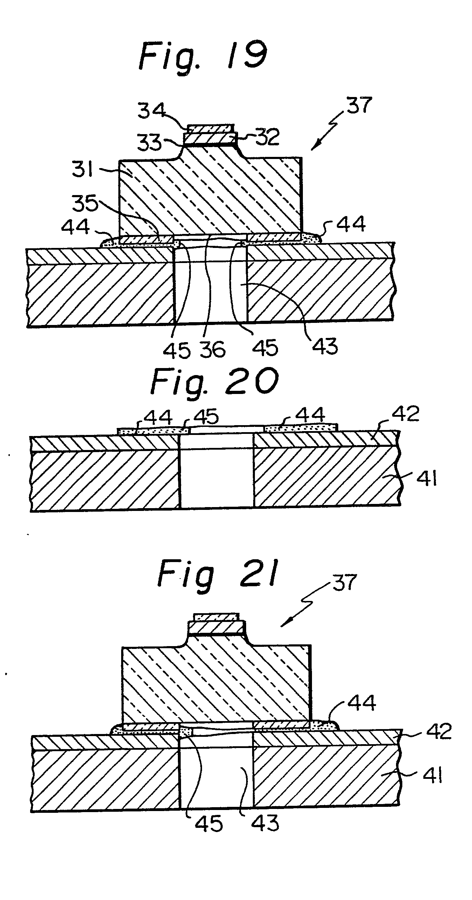

Figures 17 to 21 are sectional views showing in order the steps for assembly of a package of the ceramic substrate type. As shown in Figure 17, an electroconductive bonding pad 42 is mounted on a ceramic substrate 41 as by evaporation and a light introducing hole 43 is made through it. Then, as shown in Figure 18 a preformed solder ring 44 of Au-Sn is placed around the light introduction hole 43. Thereafter, as shown in Figure 19, the photodiode chip 37 is placed on the solder 44 and heated in a furnace to solder it.

In this structure, even through the preformed solder ring 44 and the light introduction hole 43 are aligned with each other correctly, when the chip 37 is soldered, a portion 45 of the solder sometimes overflows from the position to cover at least part of the light receiving surface thereby reducing its light receiving area. In many cases, the position of the preformed solder ring 44 is displaced to one side as shown in Figure 20. In this case, when the chip 37 is placed and soldered, there could be caused the wide overflow 45 toward one side, which covers the light receiving surface and thereby reduces the sensitivity of the photodiode. While the overflow 45 of the solder can be avoided by reducing the thickness of the solder, the thickness of the preformed solder ring must be 10 µm or larger for convenience in handling. For the reason described above, such a preformed ring 44 can reduce the light receiving area on the bottom surface of the chip to lower the sensitivity of the photodiode. Another problem is bonding strength. In the case where a solder ring preform (for example, AuSn alloy of 500 µm outer diameter, 250 µm inner diameter, and 30 µm thickness) is used for die bonding there is a time lag between melting of the preform and die bonding of the photodiode, which causes a problem of uneven contact between the bottom surface of the photodiode and the solder 44, resulting in variation in the strength of the die bonding.

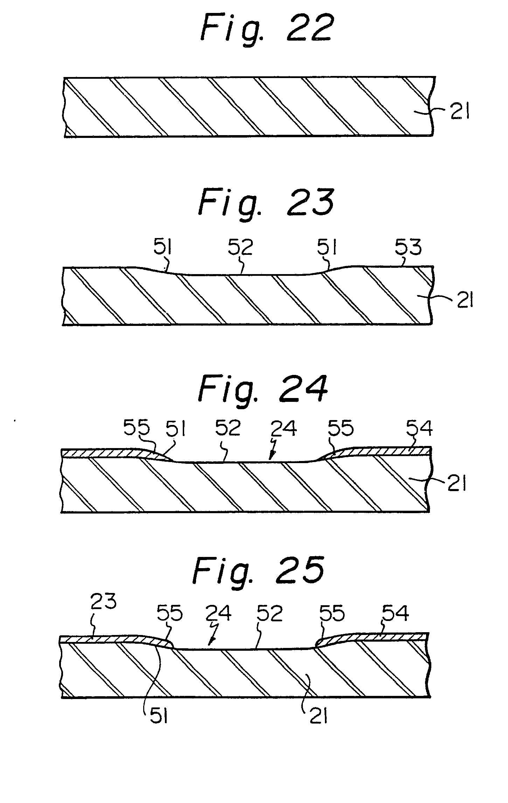

Preferred embodiments of the present invention will now be described. First of all, an embodiment for overcoming the problem in metallizing the die bonding pad 23 in a package for an optical device shown in Figures 8 and 9 will be described with reference to Figures 22 to 25. Since the problem in metallizing the die bonding pad is caused by the rising of gold paste at its edges, the sapphire substrate 21 is slightly shaved beforehand to a depth corresponding to the amount of rising of the paste in its edges.

Figure 22 is a sectional view of the sapphire substrate 21 which is flat and transparent, and is 0.2 mm in thickness in this example.

Figure 23 shows the flat sapphire substrate 21 provided with a shallow inclined portion 51 and a concavity 52 continuous thereto. The inclined portion 51 and the concavity 52 are processed by an Ar laser, but may be processed mechanically. The difference in height between an unprocessed upper surface 53 and the flat base of the concavity 52 is in the range 5 to 10 µm. Then, as shown in Figure 24, electroconductive paste 54 such as gold paste is screen-printed on the substrate 21 in the shape to be the die bonding pad 23 in such a manner that the base of the concavity 52 corresponds to the opening 24 of the pad 23. Edges 55 corresponding to the opening 24 of the paste 23 are inclined smoothly toward the concavity 52. The screen-printed paste is dried and fired in a furnace. Figure 25 is a sectional view of the sapphire substrate 21 and the paste 54 thereon after firing. By firing, the paste 54 rises in the ends 55 in height no more than 5 µm. Since the edges of the paste are located on the inclined portion 51, the edges of the paste do not rise higher than other portions of the paste so that its upper surface is substantially flat. The optical device chip 29 is die-bonded to the die bonding pad 23 thus processed. Since the rising in the ends of the paste is levelled off, there is no unequal raising of the bottom surface of the chip 29. Thereafter, a package for optical device as shown in Figures 8 and 9 is produced as described previously. Then, as shown in Figure 10, the optical device chip 29 is die-bonded, the wire 30 is wire-bonded and capsealed to form an optical device.

The package for optical device structured as described above provides the following meritorious technical effects:

(a) Safety in die bonding of the optical device chip is increased. After the gold paste is fired, the rising of its edges is substantially flat or even still below the level of its surroundings. Thus the surface of the optical device chip is in contact with the flat portions only of the die bonding pad to make the entire contact surface flat.

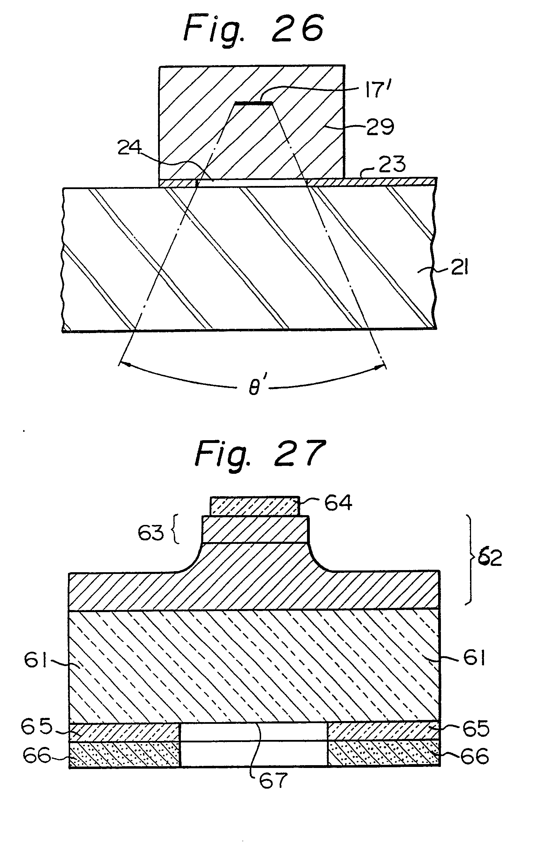

(b) The packaging of this optical device chip is, unlike that of the under surface through hole type shown in Figure 6, not severely limited in the opening angle. In the structure of the packaging according to the present invention as shown in Figure 26, the light reaching the light receiving portion 17' passes the opening 24 of the pad 23. The opening 24 is in contact with the chip 29 and is very thin. Accordingly, it is possible to let the light included in the wide opening angle $\theta'$ be incident to the light receiving portion 17'.

Now, an example will be described which overcomes the problems in fixing an optical device chip to a die bonding pad, such as overflow of the solder on to the light receiving surface and variation in the die bonding strength. In the present invention, a solder preform is not applied to the substrate side but a solder layer is applied to the chip side.

Figure 27 is a sectional view showing an example in which the present invention is applied to a mesa type photodiode chip. A non-doped InGaAs epitaxial layer 62 is grown on an Sn-doped InP substrate 61 by liquid phase epitaxial process so as to be lattice-matched to the InP substrate 61. Then, a p-type region 63 is formed by Zn diffusion, whereby a pn junction is produced. Thereafter, a p-side electrode 64 is formed by using AuZn and an n-side electrode 65 is formed by using AuGeNi.

Further, the chip is etched from both sides in the neighbourhood of the pn junction into a mesa shape to reduce its electrostatic capacity. Then, an Sn plating pattern is formed on the underside of the n-side electrode 65 using a plating solution of alkanol sulphonic acid. The Sn-plated portion is hereinafter called a solder layer 66 since it functions as solder. The solder layer 66 and the n-side electrode 65 are each in a ring shape, and the underside of the chip is exposed at the central portion which functions as a light receiving surface 67. The thickness of the solder layer 66 is 1 to 15 µm. These steps are carried out by wafer process. Thereafter, the wafer is scribed and divided into individual chips. The solder layer 66 is formed efficiently by plating or evaporation. Beside Sn, Au-Sn eutectic alloy or Au-Si eutectic alloy may be used as the material of the solder layer 66.

For die-bonding the photodiode chip thus processed using Sn as the solder, the package to be bonded is heated to 250°C and the chip with the solder layer 66 attached thereto is aligned with the pad and die-bonded to it. At this time, no other solder is necessary because the solder is necessary because the solder layer 66 on the underside of the chip is melted temporarily and then solidified to fix them securely.

In experiments, the photodiode chip was die-bonded most satisfactorily when the thickness of Sn plating was between 5 and 10 µm. When the thickness of the Sn plating was 5 µm or less, the bonding strength varied and was unstable. When the thickness of the Sn plating was 10 µm or more, the Sn solder overflowed and varied. Therefore, while the optimum range of the plating thickness depends upon the kind of the solder material, the plating thickness in the range 5 to 10 µm is generally most satisfactory.

In the present invention, the solder layer is provided on the chip side. The chip is die-bonded to the substrate of the package by the solder layer. The substrate and the package may be arbitrary in the kind of material and the shape.

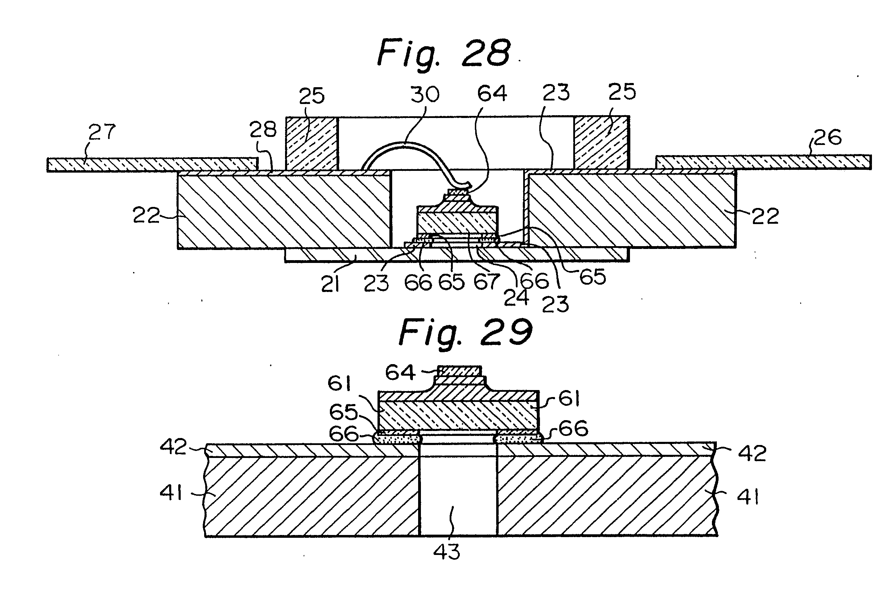

Figure 28 is a sectional view showing the structure in which said photodiode chip is mounted to a flat type package using the sapphire substrate 2 of Figures 8 and 9 produced through the steps shown in Figures 22 to 25. The optical device chip of Figure 27 is placed directly (without using new solder) on the die bonding pad 23 and die-bonded thereto to securely attach the n-side electrode 65 and the pad 23 thereto. The p-side electrode 64 is wire-bonded to the pad 28 by the wire 30. The light passes the sapphire substrate 21 and the opening 24 of the pad 23, and reaches the light receiving surface 67. In this structure, there is no overflow or dislocation of the solder layer 66.

Figure 29 is a sectional view showing the structure in which the photodiode chip is mounted to a ceramic substrate type package shown in Figure 17. Wire bonding, lead and the external shape of the package are not shown because they can be selected arbitrarily. In Figure 29, the ceramic substrate is not provided with solder, but the solder layer 66 on the chip side functions as the solder to securely attach the chip to the pad 42.

While the present invention has been described hereinabove with reference to the specific applications, it will be understood that the present invention is applicable to all optical devices such as planar type photodiodes, avalanche photodiodes (APD) and further to packaging of plane light transmission type light transmitting diodes and plane light transmission type laser diodes.

The optical device having the structure according to the present invention as described above provides the meritorious technical effects as follows:

(a) Since overflow or dislocation of the solder layer in die bonding is prevented, there is no reduction in area or space of the transparent portion for passing light by the solder. This increases the yield rate in assembly of the optical devices. When applied to a photodiode, the present invention does not decrease the sensitivity of the photodiode because the photodiode is provided with a metallized layer of such, for example, as Sn in the die bonding area other than the light receiving window. Since the thickness of the metallized layer of such as Sn can be arbitrarily controlled in the accuracy of 0.2 µm, there is no overflow of the solder.

(b) It is not necessary to provide special die-bonding agent such as solder or epoxy resin in die bonding. This makes production process simple and productivity high.

**Claims**

1. A package for an optical device including:
   a sapphire substrate (21), and
   a die bonding pad (23) formed on an upper surface of the sapphire substrate (21) by printing and subsequently firing an electroconductive paste, the electroconductive paste being absent from a region to form an opening (24) in the die bonding pad (23) to enable light to pass through the sapphire substrate (21) and the opening (24), characterised in that the upper surface of the sapphire substrate (21) includes a depression (52) having inclined sides (51), and in that the electroconductive paste (54) has its edges surrounding the opening (24) located on the inclined sides (51) of the depression (52), so that, after firing, the upper contact surface of the die bonding pad (23) is substantially flat.

2. A package for an optical device according to claim 1, wherein the depth of the depression (52) provided on the sapphire substrate (21) is between 5 and 10 µm.

3. A package for an optical device according to claim 1 or 2, wherein the inclined sides (51) are portions of the substrate (21) which gradually decrease in thickness to form the depression (52) which is bordered by the inclined sides (51).

4. An optical device comprising a package according to any one of the preceding claims, and
   an optical device chip (61) die-bonded on to the die bonding pad (23) and arranged to receive or emit light from its die-bonded side,
   the optical device chip (61) having an electrode (65) and a solder layer (66) sequentially mounted on its die-bonded side, each layer (65 and 66) having a hole for transmission of light, and,

the optical device chip (61) being die-bonded to the die bonding pad (23) by the solder layer (66) so that the holes in the solder layer and the electrode correspond to the opening (24) in the die bonding pad.

5. An optical device according to claim 4, wherein the solder layer (66) is Sn or Au-Sn eutectic alloy, or Au-Si eutectic alloy.

6. An optical device according to claim 4 or 5, wherein the solder layer (66) is formed by plating or by evaporation.

7. An optical device according to claim 4, 5, or 6, wherein the electrode (65) and the solder layer (66) are both ring-shaped.

## Patentansprüche

1. Gehäuse für eine optische Vorrichtung mit:
einem Saphir-Substrat (21) und
einer zum Befestigen eines Chip auf einem Substrat dienenden Unterlage (23), die auf einer oberen Fläche des Saphir-Substrats (21) durch Drucken und anschließendem Brennen einer elektrisch leitenden Paste ausgebildet ist, wobei die elektrisch leitende Paste zur Ausbildung einer Öffnung (24) in der Unterlage (23) in einem Bereich nicht vorgesehen ist, so daß Licht durch das Saphir-Substrat (21) und die Öffnung (24) hindurchdringen kann, dadurch gekennzeichnet, daß die obere Fläche des Saphir-Substrats (21) eine Vertiefung (52) mit geneigten Seiten (51) einschließt und daß die die Öffnung (24) umgebenden Kanten der elektrisch leitenden Paste (54) auf den geneigten Seiten (51) der Vertiefung (52) angeordnet sind, so daß nach dem Brennen die obere Kontaktfläche der zum Befestigen eines Chip auf einem Substrat dienenden Unterlage (23) im wesentlichen eben ist.

2. Gehäuse für eine optische Vorrichtung nach Anspruch 1, wobei die Tiefe der auf dem Saphir-Substrat (21) vorgesehenen Vertiefung (52) zwischen 5 und 10 μm liegt.

3. Gehäuse für eine optische Vorrichtung nach Anspruch 1 oder 2, wobei die geneigten Seiten (51) Teile des Substrats (21) sind, die allmählich in der Dicke zur Ausbildung der von den geneigten Seiten (51) begrenzten Vertiefung (52) abnehmen.

4. Optische Vorrichtung mit einem Gehäuse nach einem der vorhergehenden Ansprüche und einem eine optische Vorrichtung vorsehenden Chip (61), der auf der zum Befestigen eines Chip auf einem Substrat dienenden Unterlage (23) befestigt und so angeordnet ist, daß er von seiner Befestigungsseite Licht empfängt oder abstrahlt, wobei der eine optische Vorrichtung vorsehende Chip (61) eine Elektrode (65) und eine Lötschicht (66) aufweist, die auf seiner Befestigungsseite aufeinanderfolgend befestigt sind, wobei jede Schicht (65 und 66) ein Loch zum Durchlassen des Lichts hat, und wobei der eine optische Vorrichtung vorsehende Chip (61) mit Hilfe der Lötschicht (66) auf der Unterlage (23) so befestigt ist, daß die Löcher in der Lötschicht und der Elektrode der in der Unterlage vorgesehenen Öffnung (24) entsprechen.

5. Optische Vorrichtung nach Anspruch 4, wobei die Lötschicht (66) Sn oder eine eutektische Legierung mit Au-Sn oder eine eutektische Legierung mit Au-Si ist.

6. Optische Vorrichtung nach Anspruch 4 oder 5, wobei die Lötschicht (66) durch Galvanisierung oder durch Aufdampfung ausgebildet ist.

7. Optische Vorrichtung nach Anspruch 4, 5 oder 6, wobei die Elektrode (65) und die Lötschicht (66) beide ringförmig sind.

## Revendications

1. Boîtier pour un dispositif optique comportant:
un substrat en saphir (21), et
un plot de liaison par estampage (23) formé sur une surface supérieure du substrat en saphir (21) par impression et cuisson subséquente d'une pâte électroconductrice, la pâte électroconductrice étant absente d'une région pour former une ouverture (24) dans le plot (23) pour permettre à la lumière de traverser le substrat en saphir (21) et l'ouverture (24), caractérisé en ce que la surface supérieure du substrat en saphir (21) comprend un renfoncement (52) ayant des côtés inclinés (51) et en ce que la pâte électroconductrice (54) a ses bords entourant l'ouverture (24) placés sur les côtés inclinés (51) du renfoncement (52) de manière qu'après cuisson, la surface supérieure de contact du plot (23) soit sensiblement plate.

2. Boîtier pour un dispositif optique selon la revendication 1, où la profondeur du renfoncement (52) prévu sur le substrat au saphir (21) est comprise entre 5 et 10 μm.

3. Boîtier pour un dispositif optique selon la revendication 1 ou 2, où les côtés inclinés (51) sont des portions du substrat (21) qui diminuent graduellement en épaisseur pour former le renfoncement (52) qui est bordé par les côtés inclinés (51).

4. Dispositif optique comprenant un boîtier selon l'une quelconque des revendications précédentes; et
une pastille (61) de dispositif optique liée par estampage sur le plot (23) et agencée pour recevoir ou émettre de la lumière de son côté lié par estampage,
la pastille de dispositif optique (61) ayant une électrode (65) et une couche de soudure (66) montées séquentiellement sur son côté lié par estampage, chaque couche (65 et 66) ayant un trou pour la transmission de la lumière, et,
la pastille (61) pour dispositif optique étant liée par estampage au plot (23) par la couche de soudure (66) de manière que les trous dans la couche de soudure et dans l'électrode correspondent à l'ouverture (24) dans le plot.

5. Dispositif optique selon la revendication 4, où la couche de soudure (66) est en Sn ou en un alliage eutectique de Au-Sn, ou en un alliage eutectique de Au-Si.

6. Dispositif optique selon la revendication 4 ou 5, où la couche de soudure (66) est formée par placage ou par évaporation.

7. Dispositif optique selon la revendication 4, 5 ou 6, où l'électrode (65) et la couche de soudure (66) sont toutes deux de forme annulaire.

Fig. 1

Fig. 2

## Fig. 3

## Fig. 4

## Fig. 5

# Fig. 6

# Fig. 7

## Fig. 8

## Fig. 9

## Fig 10

*Fig. 11*

*Fig. 12*

Fig. 13

Fig. 14

Fig. 15

*Fig. 16*

*Fig. 17*

*Fig. 18*

# Fig. 19

34 33 32 37 31 35 44 44 45 36 45 43

# Fig. 20

44 45 44 42 41

# Fig 21

37 44 42 41 45 43

*Fig. 22*

~21

*Fig. 23*

51    52    51    53

~21

*Fig. 24*

55  51    52    24    55    54

~21

*Fig. 25*

23    55  24  52    55    54

51    21

## Fig. 26

## Fig. 27

## Fig. 28

## Fig. 29